# EUROPEAN PATENT APPLICATION

(11) **EP 4 806 586 A1**
(43) Date of publication of application: **16.09.2026**
(21) Application number: 24897660.7
(22) Date of filing: 28.11.2024
(51) Int. Cl.: B24B 37/30, B24B 37/005, B24B 37/12, H01L 21/304

(54) **TOP RING AND SUBSTRATE POLISHING DEVICE**

(30) Priority: 30.11.2023 JP 2023202452
(71) Applicant: EBARA CORPORATION, Ota-ku, Tokyo 144-8510 (JP)
(72) Inventor: KASHIWAGI, Makoto, Tokyo 144-8510 (JP)
(74) Representative: Wagner & Geyer
(86) International application number: PCT/JP2024/042211
(87) International publication number: WO 2025/115976

(57) **Abstract**

The present invention provides a top ring or a substrate polishing apparatus capable of achieving a polishing profile further consistent between the central side of a polygonal substrate and the outer edge side of the substrate. A top ring for holding a polygonal substrate is proposed. The top ring includes a base member coupled to a rotational shaft, a substrate suction member, and a biasing mechanism. The substrate suction member includes a substrate suction body having a substrate suction surface for sucking the substrate and provided in communication with a pressure reduction module, a shielding member configured to shield an opposite surface of the substrate suction body from the substrate suction surface, and a frame member connected to the shielding member so as to surround at least a part of the base member. The biasing mechanism has a first end portion in contact with the base member and a second end portion in contact with the frame member, and is configured to apply a biasing force in a direction for moving the base member and the frame member toward or away from each other.

## Description

### TECHNICAL FIELD

The present application relates to a top ring and a substrate polishing apparatus.

### BACKGROUND ART

To manufacture semiconductor devices, chemical mechanical polishing (CMP) apparatuses are used to planarize the surfaces of substrates. Most of the substrates used to manufacture the semiconductor devices are disk-shaped. Further, requirements for flatness when the surfaces are planarized are also becoming increasingly strict for not only the semiconductor devices but also quadrangular substrates, such as copper clad laminate substrates (CCL substrates), printed circuit board (PCB) substrates, photomask substrates, and display panels. Further, there is also a growing demand for planarization of the surfaces of package substrates on which electronic devices, such as PCB substrates, are mounted.

Substrate polishing apparatuses include a top ring for holding a substrate. For example, as described in PTL 1, the top ring includes a rotational shaft, a flange coupled to the rotational shaft, a suction plate fitted to an opening formed on the lower surface of the flange, and a shielding plate attached to the upper surface of the suction plate. This top ring is configured to suck a substrate via the suction plate by means of vacuum suction and apply a pressure to the shielding plate, thereby pressing the substrate against a polishing pad.

### CITATION LIST

### PATENT LITERATURE

PTL 1: Japanese Patent Application Laid-Open No. 2023-57047

### SUMMARY OF INVENTION

### TECHNICAL PROBLEM

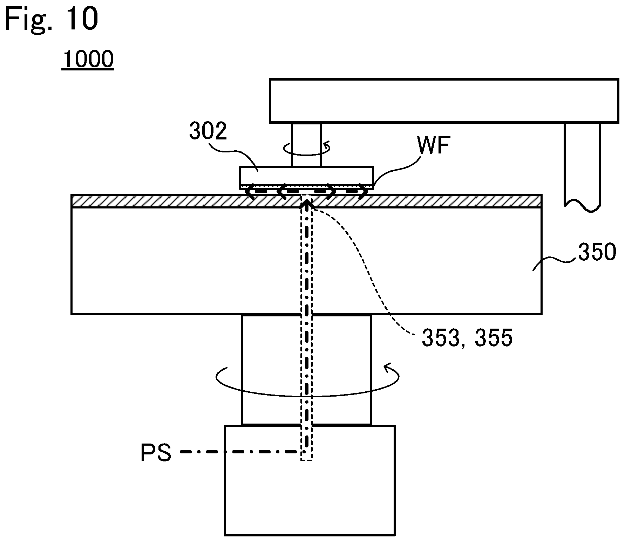

The above-described top ring may lead to an uneven film thickness of the substrate after the polishing treatment between the central side of the substrate and the outer edge side of the substrate. Especially, when a polygonal substrate is polished, a substrate corner portion may be polished by a smaller amount than the polishing amount of the substrate central portion. This is considered to be attributed to the fact that, when the top ring presses the substrate via the shielding plate, a force in a direction for causing an upward warp is generated on the substrate corner portion, and the substrate corner portion is subjected to less pressing than the pressing on the substrate central portion. Further, as illustrated in Fig. 10, in a substrate polishing apparatus 1000, polishing slurry PS is supplied from a passage 353 (an opening portion 355) formed on a polishing table 350 to the center of a polygonal substrate WF held on a top ring 302, and this polishing slurry PS may spread to the outer edge side along the plate surface of the substrate WF to thus be supplied to the outer edge side of the substrate WF (refer to an arrowed dot-dash line). This treatment may proceed with a smaller amount of polishing slurry PS supplied to the substrate corner portion than the central side of the substrate, thereby ending up polishing the substrate corner portion by a smaller amount than the polishing amount of the substrate central portion. Alternatively, the outer edge side of the polygonal substrate may be polished by a larger amount than the polishing amount of the central side of the substrate depending on the polishing environment.

In consideration of the above-described circumstances, one of objects of the present application is to provide a top ring or a substrate polishing apparatus capable of achieving a polishing profile further consistent between the central side of a polygonal substrate and the outer edge side of the substrate.

### SOLUTION TO PROBLEM

According to one aspect of the present invention, a top ring for holding a polygonal substrate is proposed. The top ring includes a base member coupled to a rotational shaft, a substrate suction member, and a biasing mechanism. The substrate suction member includes a substrate suction body having a substrate suction surface for sucking the substrate and provided in communication with a pressure reduction module, a shielding member configured to shield an opposite surface of the substrate suction body from the substrate suction surface, and a frame member connected to the shielding member so as to surround at least a part of the base member. The biasing mechanism has a first end portion in contact with the base member and a second end portion in contact with the frame member, and is configured to apply a biasing force in a direction for moving the base member and the frame member toward or away from each other.

### BRIEF DESCRIPTION OF DRAWINGS

Fig. 1 is a plan view illustrating the overall configuration of a substrate polishing apparatus according to one embodiment.
Fig. 2 is a perspective view schematically illustrating the configuration of a polishing unit according to one embodiment.
Fig. 3 is a cross-sectional view schematically illustrating a top ring according to one embodiment.
Fig. 4 is a cross-sectional perspective view schematically illustrating a top ring according to one embodiment.
Fig. 5 is a perspective view schematically illustrating a substrate suction member according to one embodiment.
Fig. 6 is an enlarged view of a region AA illustrated in Fig. 5.
Fig. 7 illustrates a portion that a biasing mechanism is in contact with according to a modification.
Fig. 8 is a cross-sectional view schematically illustrating a top ring according to a modification.
Fig. 9 illustrates one example of a portion in a frame member that a piston or an elastic member is in contact with.
Fig. 10 illustrates one example of a substrate polishing apparatus according to a reference example.

In the following description, embodiments of the present invention will be described with reference to the drawings. In the drawings that will be described below, identical or corresponding components will be indicated by the same reference numerals, and redundant descriptions will be omitted.

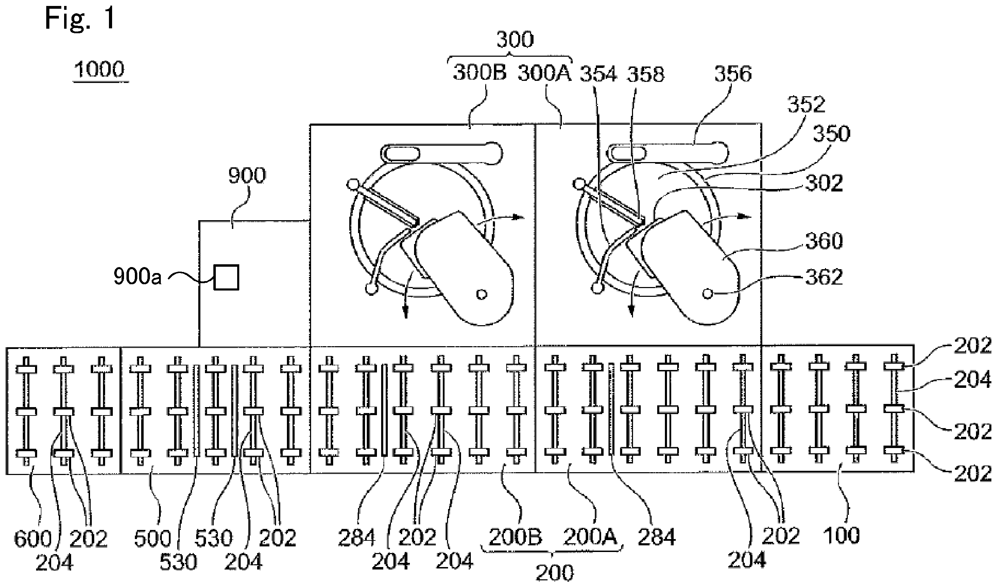

Fig. 1 is a plan view illustrating the overall configuration of a substrate polishing apparatus 1000 according to one embodiment. The substrate polishing apparatus 1000 illustrated in Fig. 1 includes a load unit 100, a conveyer unit 200, a polishing unit 300, a drying unit 500, and an unload unit 600. In the illustrated embodiment, the conveyer unit 200 includes two conveyer units 200A and 200B, and the polishing unit 300 includes two polishing units 300A and 300B. The substrate polishing apparatus 1000 may include one or three or more conveyer unit(s) 200, and one or three or more polishing unit(s) 300. In one embodiment, each of these units can be formed independently. Forming these units independently allows a differently configured substrate polishing apparatus 1000 to be easily constructed by combining the numbers of respective units in any manner. Further, the substrate polishing apparatus 1000 includes a controller 900, and each component of the substrate polishing apparatus 1000 is controlled by the controller 900. In one embodiment, the controller 900 can be composed of a general computer including an input/output device, a computing device, a storage device (storage medium) 900a, and the like. The controller 900 functions as an operating entity of controlling the substrate polishing apparatus 1000. The controller 900 performs various kinds of processing by reading and executing a program stored in the storage device 900a or the like. A program recorded on a recording medium such as a DVD-ROM may be acquired as the program, or the program may be acquired via a network.

### <Load Unit>

The load unit 100 is a unit for introducing a substrate WF into the substrate polishing apparatus 1000 before the substrate WF is polished, cleaned, or otherwise treated. In one embodiment, the load unit 100 is configured in compliance with Surface Mount Equipment Manufacturers Association (SMEMA) mechanical device interface standards (IPC-SMEMA-9851).

In the illustrated embodiment, a conveyer mechanism of the load unit 100 includes a plurality of conveying rollers 202, and a plurality of roller shafts 204 to which the conveying rollers 202 are attached. In the embodiment illustrated in Fig. 1, three conveying rollers 202 are attached to each of the roller shafts 204. The substrate WF is disposed on the conveying rollers 202, and the substrate WF is conveyed due to rotations of the conveying rollers 202. Each of the conveying rollers 202 can be attached at any position on the roller shaft 204 that allows it to stably convey the substrate WF. However, the conveying roller 202 contacts the substrate WF, and therefore the conveying roller 202 is preferably disposed so as to contact a region that keeps any problem from occurring even when the conveying roller 202 contacts the treatment target substrate WF. In one embodiment, the conveying roller 202 of the load unit 100 can be made from a conductive polymer. In one embodiment, the conveying roller 202 is electrically grounded via the roller shaft 204 or the like. The purpose thereof is to prevent the substrate WF from being charged and incurring damage. Further, in one embodiment, an ionizer (not illustrated) may be provided to the load unit 100 to prevent the substrate WF from being charged.

### <Conveyer Unit>

The substrate polishing apparatus 1000 illustrated in Fig. 1 includes the two conveyer units 200A and 200B. The two conveyer units 200A and 200B can be configured identically, and therefore will be described below collectively referring to them as a conveyer unit 200.

The illustrated conveyer unit 200 includes a plurality of conveying rollers 202 for conveying the substrate WF. The substrate WF on the conveying rollers 202 can be conveyed in a predetermined direction by rotating the conveying rollers 202. The conveying rollers 202 of the conveyer unit 200 may be made from a conductive polymer or may be made from a non-conductive polymer.

In one embodiment, the conveyer unit 200 includes a cleaning nozzle 284. The cleaning nozzle 284 is connected to a not-illustrated supply source of cleaning liquid. The cleaning nozzle 284 is configured to supply the cleaning liquid to the substrate WF conveyed by the conveying rollers 202.

### <Polishing Unit>

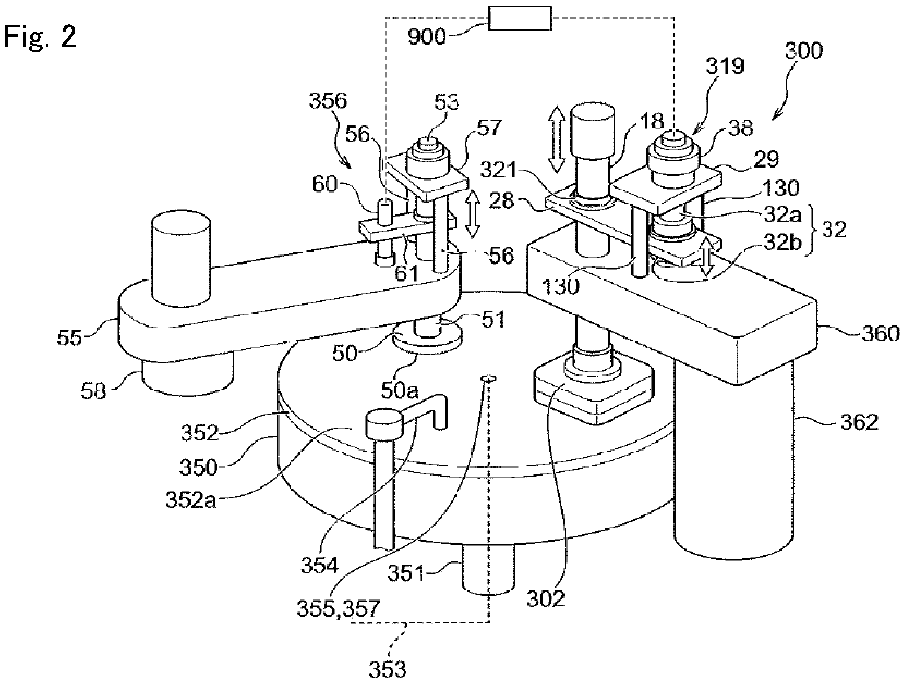

Fig. 2 is a perspective view schematically illustrating the configuration of the polishing unit 300 according to one embodiment. The substrate polishing apparatus 1000 illustrated in Fig. 1 includes the two polishing units 300A and 300B. The two polishing units 300A and 300B can be configured identically, and therefore will be described below collectively referring to them as a polishing unit 300.

As illustrated in Fig. 2, the polishing unit 300 includes a polishing table 350, and a top ring 302 constituting a polishing head that holds a polishing target substrate and presses the substrate against a polishing surface on the polishing table 350. The polishing table 350 is coupled to a polishing table rotation motor (not illustrated) disposed below a table shaft 351 via the table shaft 351 and is rotatable about this table shaft 351. A polishing pad 352 is bonded to the upper surface of the polishing table 350, and a surface 352a of the polishing pad 352 constitutes a polishing surface that polishes the substrate.

A polishing liquid supply nozzle 354 is installed above the polishing table 350, and this polishing liquid supply nozzle 354 is configured to supply polishing liquid onto the polishing pad 352 on the polishing table 350. Further, as illustrated in Fig. 2, the polishing table 350 and the table shaft 351 are provided with a passage 353 for supplying the polishing liquid. The passage 353 is in communication with an opening portion 355 on the surface of the polishing table 350. The polishing pad 352 includes a through-hole 357 formed at a position corresponding to the opening portion 355 of the polishing table 350, and the polishing liquid passing through the passage 353 is supplied to the surface of the polishing pad 352 via the opening portion 355 of the polishing table 350 and the through-hole 357 of the polishing pad 352. The polishing table 350 may include no or one or more opening portion(s) 355, and the polishing pad 352 may include no or one or more through-hole(s) 357. Further, the opening portion 355 of the polishing table 350 and the through-hole 357 of the polishing pad 352 may be located at any position, but are disposed near the center of the polishing table 350 in one embodiment. In one embodiment, the substrate WF held by the top ring 302 is moved so as to pass through near the center of the polishing table 350 (so as to cover the through-hole 357) while the substrate is polished (refer to Fig. 10).

In one embodiment, the polishing unit 300 includes an atomizer 358 (refer to Fig. 1) for spraying liquid or mixed fluid of liquid and gas toward the polishing pad 352, although this is not illustrated in Fig. 2. The liquid sprayed from the atomizer 358 is, for example, pure water, and the gas is, for example, nitrogen gas.

The top ring 302 is connected to a top ring shaft 18, and this top ring shaft 18 is configured to be moved up and down relative to a swingable arm 360 by an upward/downward moving mechanism 319. The top ring 302 is configured to be positioned by being entirely moved up or down relative to the swingable arm 360 due to this upward/downward movement of the top ring shaft 18. The top ring shaft 18 is configured to rotate by being driven by a not-illustrated top ring rotation motor. The top ring 302 is configured to rotate about the top ring shaft 18 due to the rotation of the top ring shaft 18.

The top ring 302 is configured to be able to hold a polygonal substrate on the lower surface thereof. As will be used herein, the term "polygonal substrate" refers to a substrate having a plate surface in a triangular shape, a quadrangular shape, or a polygonal shape having five or more sides. The swingable arm 360 is configured pivotably about a spindle 362. The pivoting movement of the swingable arm 360 allows the top ring 302 to move between a substrate transfer position of the above-described conveyer unit 200 and a position above the polishing table 350. Lowering the top ring shaft 18 allows the top ring 302 to be moved down to press the substrate against the surface (polishing surface) 352a of the polishing pad 352. At this time, the top ring 302 and the polishing table 350 are each rotated, and the polishing liquid is supplied onto the polishing pad 352 from the polishing liquid supply nozzle 354 provided above the polishing table 350 and/or from the opening portion 355 provided to the polishing table 350. In this manner, the surface of the substrate can be polished by pressing the substrate against the polishing surface 352a of the polishing pad 352. As described above, the arm 360 may be fixed or swingably moved in such a manner that the top ring 302 passes through the center of the polishing pad 352 (covers the through-hole 357 of the polishing pad 352) while the substrate WF is polished (refer to Fig. 10).

The upward/downward moving mechanism 319, which moves up and down the top ring shaft 18 and the top ring 302, includes a bridge 28 rotatably supporting the top ring shaft 18 via a bearing 321, a ball screw 32 attached to the bridge 28, a support base 29 supported by support posts 130, and an AC servo motor 38 provided on the support base 29. The support base 29, which supports the servo motor 38, is fixed to the swingable arm 360 via the support posts 130.

The ball screw 32 includes a screw shaft 32a coupled to the servo motor 38, and a nut 32b with which the screw shaft 32a is threadedly engaged. The top ring shaft 18 is configured upward and downward movably integrally with the bridge 28. Therefore, when the servo motor 38 is driven, the bridge 28 is moved up and down via the ball screw 32, and the top ring shaft 18 and the top ring 302 are moved up and down according thereto.

The polishing unit 300 according to one embodiment includes a dressing unit 356, which dresses the polishing surface 352a of the polishing pad 352. This dressing unit 356 includes a dresser 50, which slidably contacts the polishing surface 352a, a dresser shaft 51, to which the dresser 50 is coupled, an air cylinder 53, which is provided at the upper end of the dresser shaft 51, and a swingable arm 55, which rotatably supports the dresser shaft 51. The lower portion of the dresser 50 is composed of a dressing member 50a, and needle-shaped diamond particles adhere on the lower surface of this dressing member 50a. The air cylinder 53 is disposed on a support base 57 supported by support posts 56, and these support posts 56 are fixed to the swingable arm 55.

The swingable arm 55 is configured to pivot about a spindle 58 by being driven by a not-illustrated motor. The dresser shaft 51 rotates by being driven by the not-illustrated motor, and the dresser 50 is configured to rotate about the dresser shaft 51 due to this rotation of the dresser shaft 51. The air cylinder 53 moves up and down the dresser 50 via the dresser shaft 51 and presses the dresser 50 against the polishing surface 352a of the polishing pad 352 with a predetermined pressing force.

The polishing surface 352a of the polishing pad 352 is dressed in the following manner. The dresser 50 is pressed against the polishing surface 352a by the air cylinder 53, and pure water is supplied to the polishing surface 352a via a not-illustrated pure water supply nozzle at the same time as that. In this state, the dresser 50 rotates about the dresser shaft 51, and, along therewith, the swingable arm 55 swings above the polishing surface 352a to place the lower surface (diamond particles) of the dressing member 50a into sliding contact with the rotating polishing surface 352a. In this manner, the polishing pad 352 is scraped off by the dresser 50, and the polishing surface 352a is dressed.

### <Drying Unit>

The drying unit is a device for drying the substrate WF. In the substrate polishing apparatus 1000 illustrated in Fig. 1, the drying unit 500 dries the substrate WF cleaned by the cleaning unit of the conveyer unit 200 after the substrate WF is polished by the polishing unit 300. As illustrated in Fig. 1, the drying unit 500 is disposed downstream of the conveyer unit 200. The drying unit 500 includes a nozzle 530 for injecting gas toward the substrate WF conveyed on the conveying rollers 202. The gas can be, for example, compressed air or nitrogen. The substrate WF can be dried by blowing off water drops on the conveyed substrate WF using the drying unit 500.

### <Unload Unit>

The unload unit 600 is a unit for unloading the substrate WF out of the substrate polishing apparatus 1000 after the substrate WF is polished, cleaned, or otherwise treated. In the substrate polishing apparatus 1000 illustrated in Fig. 1, the unload unit 600 receives the substrate dried by the drying unit 500. As illustrated in Fig. 1, the unload unit 600 is disposed downstream of the drying unit 500. In one embodiment, the unload unit 600 is configured in compliance with Surface Mount Equipment Manufacturers Association (SMEMA) mechanical device interface standards (IPC-SMEMA-9851).

### <Top Ring>

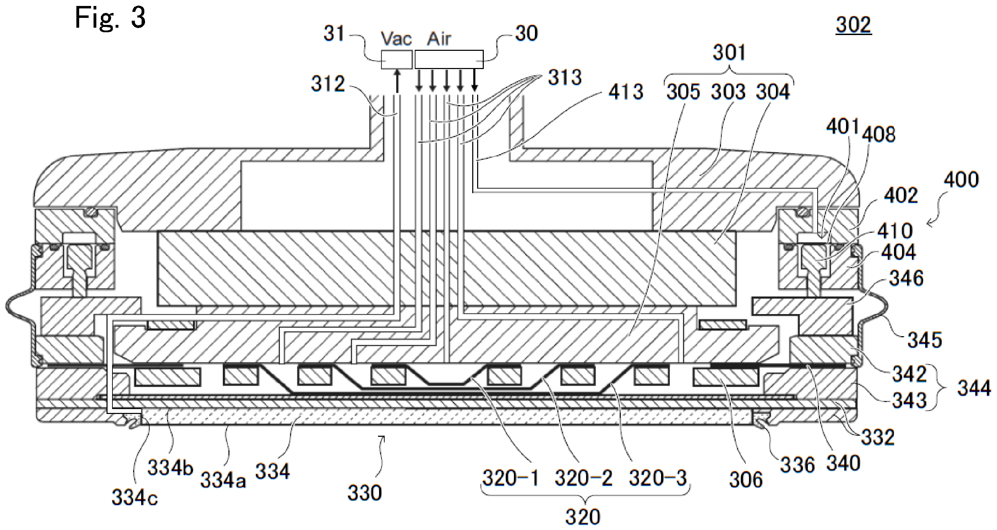

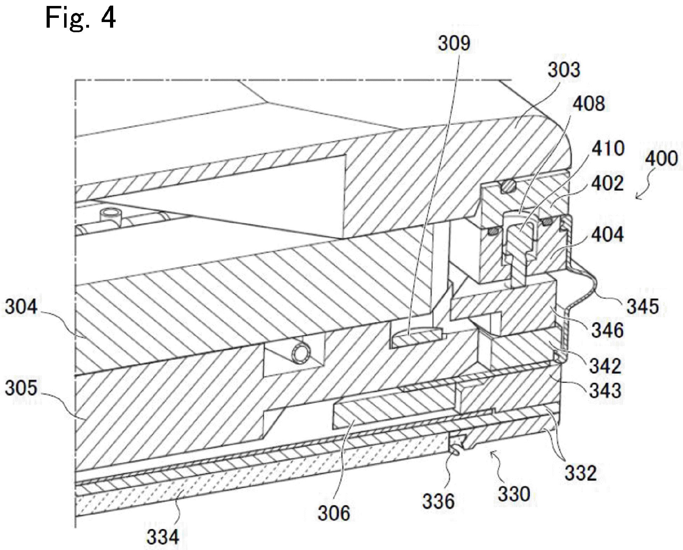

Next, the top ring 302 in the polishing unit 300 according to one embodiment will be described. Figs. 3 and 4 are a cross-sectional view and a cross-sectional perspective view schematically illustrating the top ring 302 according to one embodiment. As illustrated in Figs. 3 and 4, the top ring 302 includes a base member 301, which is coupled to the top ring shaft (rotational shaft) 18. As one specific example, the base member 301 includes a flange 303, which is coupled to the top ring shaft 18, a spacer 304, which is attached to the lower surface of the flange 303, an upper guide member 305, which is attached to the lower surface of the spacer 304, and a lower guide member 306, which is provided under the lower surface of the upper guide member 305. The flange 303, the spacer 304, and the upper guide member 305 are fixed using a not-illustrated bolt. The upper guide member 305 and the lower guide member 306 are fixed using a not-illustrated bolt via an elastic member 340. The elastic member 340 is made from a rubber material such as silicon rubber, ethylene propylene diene monomer rubber (EPDM), or fluoroelastomer (FKM), but is not limited thereto. The lower guide member 306 is provided along the peripheral edge portion of the lower surface of the upper guide member 305 in a frame-like manner.

Further, the top ring 302 includes a substrate suction member 330 for sucking the back surface of the substrate WF with a polishing target surface facing down. The substrate suction member 330 is disposed below the base member 301. The substrate suction member 330 includes a substrate suction body 334. The substrate suction body 334 may be any member capable of vacuum-suctioning the substrate WF by means of evacuation using a pressure reduction module (vacuum source) 31. The substrate suction body 334 can be made from, for example, a resin porous material (a porously-structured material) with a large number of small holes formed in resin, such as polyethylene (PE), polypropylene (PP), polytetrafluoroethylene (PTFE), or polyvinyl chloride (PVC). The substrate suction body 334 is formed into a plate-like shape in the present embodiment, and the lower surface thereof defines a substrate suction surface 334a for sucking the substrate WF.

Further, the substrate suction member 330 includes a shielding member 332. The shielding member 332 may be any air-tight member capable of blocking a gas flow, and can be made of a resin plate of, for example, relatively soft polyethylene (PE), polypropylene (PP), polytetrafluoroethylene (PTFE), or polyvinyl chloride (PVC). The shielding member 332 is formed so as to shield an opposite surface 334b of the substrate suction body 334 from the substrate suction surface 334a in the present embodiment. Further, the shielding member 332 includes a suction path 312 formed in communication with the surface 334b or a side surface 334c of the substrate suction body 334.

The shielding member 332 according to the present embodiment includes a frame-shaped elastic seal member 336, which covers the side surface 334c of the substrate suction body 334. The elastic seal member 336 may be attached to the main body of the shielding member 332 by any means such as a double-sided adhesive tape. The elastic seal member 336 may be any member elastic and capable of blocking a gas flow. For example, a soft member chemical-resistant, highly stretchable, and having a skin-like surface can be used as the elastic seal member 336. For example, silicone sponge, silicone rubber, or Norseal (registered trademark) made from soft polyvinyl chloride can be employed as the elastic seal member 336. In the example illustrated in Figs. 3 and 4, the elastic seal member 336 includes a lip portion extending from the lower end outward. However, the elastic seal member 336 is not limited to such an example, and, for example, may have a rectangular cross section or a circular cross section. Alternatively, the shielding member 332 does not have to include the elastic seal member 336, and may be formed so as to shield the side surface 334c of the substrate suction body 334.

The provision of the shielding member 332 can facilitate efficient generation of a negative pressure in the substrate suction surface 334a when the substrate suction body 334 is evacuated by the pressure reduction module (vacuum source) 31. This can ensure that the substrate WF is sucked to the substrate suction member 330, thereby preventing the substrate WF from flying off outward (slipping out) while being polished even without a retainer member provided around the substrate WF. Further, in the case where the shape of the substrate WF is polygonal, the corner portion of the substrate WF might contact the retainer member while the substrate WF is polished, and the substrate WF or the top ring might incur damage. On the other hand, according to the present embodiment, the substrate WF can be pressed against the polishing pad 352 while being vacuum-sucked by the substrate suction member 330, and therefore the substrate WF can be prevented from slipping out while being polished, and the substrate WF or the top ring can also be prevented from incurring damage while the substrate WF is polished.

As illustrated in Figs. 3 and 4, the substrate suction member 330 includes a frame member 344 provided on the shielding member 332 so as to surround at least a part (more specifically, the upper guide member 305 and the lower guide member 306) of the base member 301 around it. The frame member 344 includes a lower frame member 343, which is provided along the peripheral edge portion of the upper surface of the shielding member 332 in a frame-like manner, a frame-like upper frame member 342, which is provided on the lower frame member 343, and a stopper 346, which is provided on the upper frame member 342. As one example, the shielding member 332 and the frame member 344 are fixed using a not-illustrated bolt. Further, the upper frame member 342 and the lower frame member 343 are coupled to each other via the elastic member 340.

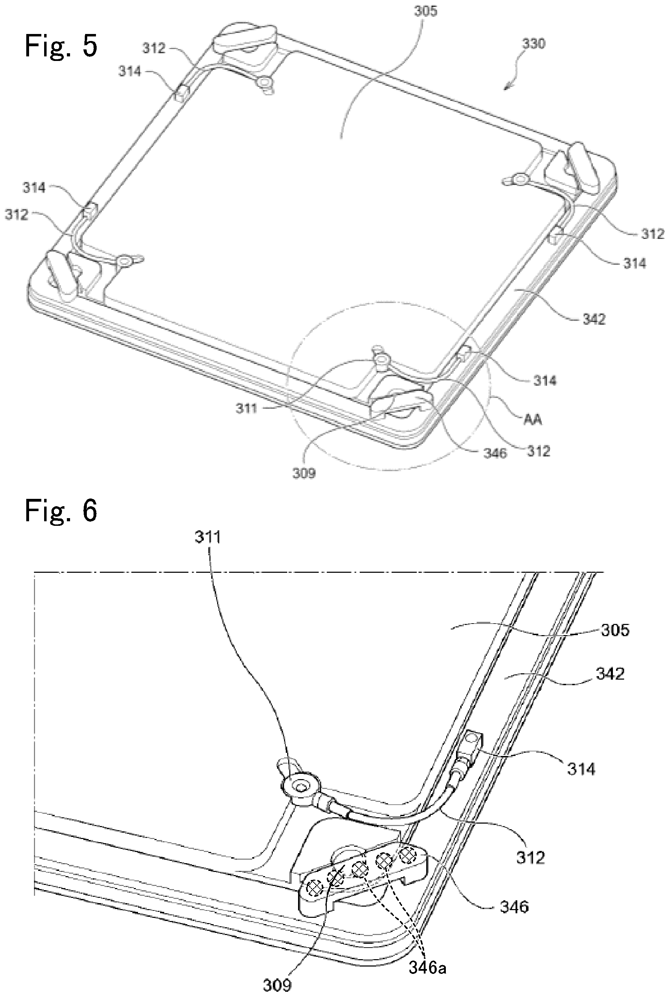

Fig. 5 is a perspective view schematically illustrating a substrate suction member according to one embodiment, and Fig. 6 is an enlarged view of a region AA illustrated in Fig. 5. Figs. 5 and 6 also illustrate the upper guide member 305 in the base member 301 along therewith for facilitating a better understanding. As illustrated in Fig. 5, in the present embodiment, suction ports 314 are provided at four portions of the substrate suction member 330. Each of the suction ports 314 is connected to the not-illustrated pressure reduction module 31 via the suction path 312 and a suction connector 311.

As illustrated in Figs. 5 and 6, the upper frame member 342 includes the stopper 346 provided at each of four corners of the upper frame member 342. The stopper 346 is configured to connect different portions of the upper frame member 342 in an arch-like manner across inside the frame, and, in the present embodiment, is configured to connect two sides forming the corner of the upper frame member 342 in an arch-like manner. On the other hand, the upper guide member 305 of the base member 301 includes a pad 309 provided at each of four corners of the upper guide member 305. The pad 309 is provided at a position corresponding to the stopper 346. The pad 309 is formed in a disk-like manner at the corner of the upper frame member 342 at a height position different from the stopper 346. The stopper 346 and the pad 309 overlap each other in a predetermined region when the top ring 302 is viewed in a planer view (as viewed from a direction perpendicular to the substrate suction surface 334a). Therefore, a movement of the substrate suction member 330 in the height direction can be restricted due to contact between the stopper 346 and the pad 309. The pad 309 corresponds to one example of a "contact portion" that limits a movement relative to the base member 301 in the height direction by contacting the stopper 346.

Referring back to Fig. 3, the top ring 302 includes an elastic membrane 320 configured to form a pressing chamber for pressing the substrate WF between the base member 301 and the substrate suction member 330. In the present embodiment, the elastic membrane 320 includes a plurality of stacked elastic membranes 320-1, 320-2, and 320-3 different in area. The elastic membranes 320-1, 320-2, and 320-3 each include a central portion in contact with the upper surface of the shielding member 332, and an end portion extending from the central portion and fixed at a different position of the lower surface of the upper guide member 305. A plurality of concentric pressing chambers for pressing the substrate WF is formed between the base member 301 and the plurality of elastic membranes 320-1, 320-2, and 320-3 due to the plurality of elastic membranes 320-1, 320-2, and 320-3. The plurality of pressing chambers is each in communication with a pressure adjustment unit (fluid supply source) 30 via a pressing path 313. The pressure adjustment unit 30 has a pressure adjustment function of adjusting the pressure of pressure fluid supplied to each pressing chamber. The formation of the plurality of pressing chambers allows the substrate WF to be pressed against the polishing pad 352 via the substrate suction member 330 with a pressing force controlled area by area. According to the present embodiment, the top ring 302 can suck the substrate WF to the substrate suction surface 334a by generating a negative pressure in the substrate suction body 334 using the pressure reduction module 31, and also press the substrate WF against the polishing pad 352 via the substrate suction member 330 by increasing the pressures in the pressing chambers using the pressure adjustment unit 30. The top ring 302 is not limited to the example in which the plurality of concentric pressing chambers is formed, and may be configured in such a manner that a plurality of circumferentially divided pressing chambers is formed. Further, the elastic membrane 320 is not limited to the example constituted by a plurality of stacked membranes, and may have a partition wall that defines a plurality of pressing chambers. As one example, an elastic membrane formed using a mold as disclosed in Japanese Patent No. 7074606 may be used as the elastic membrane 320. Further, the top ring 302 may include a single pressing chamber formed therein without including the elastic membrane 320.

As illustrated in Figs. 3 and 4, the top ring 302 includes a biasing mechanism 400 configured to bias the frame member 344 of the substrate suction member 330 vertically. The biasing mechanism 400 according to the present embodiment is constituted by a pneumatic actuator. More specifically, the biasing mechanism 400 includes a cylinder 401, which is attached to the base member 301, a diaphragm 408, which is disposed in the cylinder 401, and a piston 410, which is in contact with the frame member 344. The cylinder 401 is defined by an upper cylinder housing 402, which is attached to the lower surface of the outer peripheral portion of the flange 303 of the base member 301, and a lower cylinder housing 404, which is attached to the lower surface of the upper cylinder housing 402. The upper cylinder housing 402 and the lower cylinder housing 404 are made from polyphenylene sulfide (PPS) resin by way of example. The diaphragm 408 is made from a rubber material by way of example, and is fixed by being sandwiched between the upper cylinder housing 402 and the lower cylinder housing 404. The inner space in the cylinder 401 is partitioned into an upper space and a lower space by the diaphragm 408. The piston 410 is disposed in the lower space of the cylinder 401. The upper end of the piston 410 is in contact with the lower surface of the diaphragm 408, and the lower end of the piston 410 extends out of the lower side of the lower cylinder housing 404 into contact with the frame member 344. In one embodiment, the piston 410 is made from resin such as PPS resin, metal, or ceramic. The piston 410 made from resin is advantageous in terms of a reduction in the weight thereof.

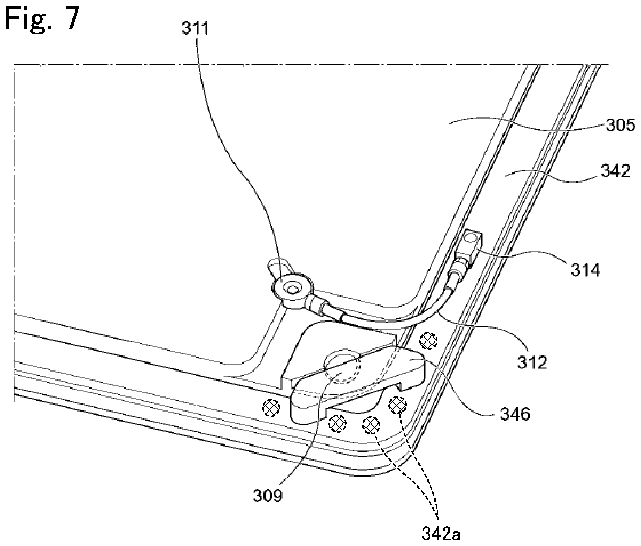

In one embodiment, the top ring 302 includes a plurality of biasing mechanisms 400. As one example, each of the plurality of biasing mechanisms 400 is desirably provided near the corner portion of the polygonal substrate WF. However, the biasing mechanism 400 is not limited to being provided near all the corner portions of the polygonal substrate WF, and may be provided near a part of the corner portions. Further, one end of each of the biasing mechanism 400 (a second end portion) may be in contact with the stopper 346 of the frame member 344. As one example, the biasing mechanism 400 may be configured in such a manner that the piston 410 is in contact with hatched regions 346a in Fig. 6 (a plurality of portions for each stopper 346). However, the biasing mechanism 400 is not limited to such an example, and may be configured in such a manner that the one end of the biasing mechanism 400 (the second end portion) is in direct contact with the upper frame member 342 instead of or in addition to the stopper 346. Fig. 7 illustrates a portion that the biasing mechanism 400 is in contact with according to a modification. As illustrated in Fig. 7, the biasing mechanism 400 may be configured in such a manner that the one end thereof (the second end portion) is in contact with hatched regions 342a of the upper frame member 342 by way of example. In other words, the biasing mechanism 400 may be configured in contact with a region closer to the corner portion than the stopper 346 or may be configured in contact with the upper frame member 342 near the stopper 346. Preferably, the end portion of the biasing mechanism 400 in contact with the base member 301 (the first end portion) and the end portion of the biasing mechanism 400 in contact with the frame member 344 (the second end portion) are spaced apart from the pressing chamber formed by the elastic membrane 320 and/or the substrate suction body 334 when the top ring 302 is viewed in a planar view (as viewed from the direction perpendicular to the substrate suction surface 334a).

As illustrated in Figs. 3 and 4, the upper cylinder housing 402 is in communication with the pressure adjustment unit 30 via a pressing path 413. The number of parts of the top ring 302 can be reduced by using the pressure adjustment unit 30 for pressing the substrate WF as a driving source in the biasing mechanism 400 in this manner. However, the top ring 302 may include a pressure supply source as a driving source in addition to the pressure adjustment unit 30 for pressing the substrate WF. When working fluid (for example, air or nitrogen) is supplied from the pressure adjustment unit 30 into the upper space of the cylinder 401, the diaphragm 408 expands downward to move the piston 410 downward. The frame member 344 can be biased downward by moving the piston 410 downward.

In one embodiment, the top ring 302 further includes a band 345, which connects the outer side surface of the base member 301 and the outer side surface of the frame member 344, as illustrated in Fig. 3. In the example illustrated in Fig. 3, more specifically, the band 345 is attached across from the outer side surface of the upper cylinder housing 402 to the outer side surface of the upper frame member 342. The band 345 allows the substrate suction member 330 to be displaced relative to the base member 301 and also prevents the polishing liquid or the like from leaking into a space between the substrate suction member 330 and the base member 301.

The top ring 302 configured in this manner can evacuate the substrate suction body 334 by the pressure reduction module (vacuum source) 31 and suck the substrate WF to the substrate suction surface 334a. Then, the top ring 302 can press the substrate WF against the polishing pad 352 via the substrate suction member 330 by increasing the pressures in the pressing chambers using the pressure adjustment unit 30. At this time, it may be effective that the controller 900 controls the pressure supply to the pressing chambers in such a manner that the film thickness distribution of the substrate WF matches a target distribution. As one example, the controller 900 may control the pressure adjustment unit 30 based on a recipe predetermined based on, for example, the property of the substrate WF. Further, a sensor for measuring the film thickness of the substrate WF may be provided to the substrate polishing apparatus 1000, and the controller 900 may acquire information from the sensor while the substrate is polished, and control the pressure adjustment unit 30 based on the acquired information. An eddy current sensor, an optical sensor, or a microwave sensor can be employed as the sensor for measuring the film thickness of the substrate WF. Further, the controller 900 may correct the subsequent control of the pressure adjustment unit 30 based on a polishing profile of the substrate WF after the polishing.

Further, the top ring 302 according to the present embodiment can press the substrate WF against the polishing pad 352 by biasing the frame member 344 of the substrate suction member 330 using the biasing mechanism 400, in addition to pressing the substrate suction body 334 by the elastic membrane 320. Due to that, the present embodiment can adjust the polishing amount on the outer edge portion of the substrate WF that is likely to be polished by a different polishing amount compared with the central portion of the substrate WF, thereby achieving a polishing profile consistent between the central side and the outer edge side of the polygonal substrate. More specifically, the controller 900 may control the biasing force exerted by the biasing mechanism 400 based on a recipe predetermined in such a manner that the film thickness distribution of the substrate WF matches the target distribution. Further, a sensor for measuring the film thickness of the substrate WF may be provided to the substrate polishing apparatus 1000, and the controller 900 may acquire information from the sensor while the substrate is polished, and control the biasing mechanism 400 based on the acquired information. Further, the controller 900 may correct the subsequent control of the biasing mechanism 400 based on a polishing profile of the substrate WF after the polishing.

### <Modification 1>

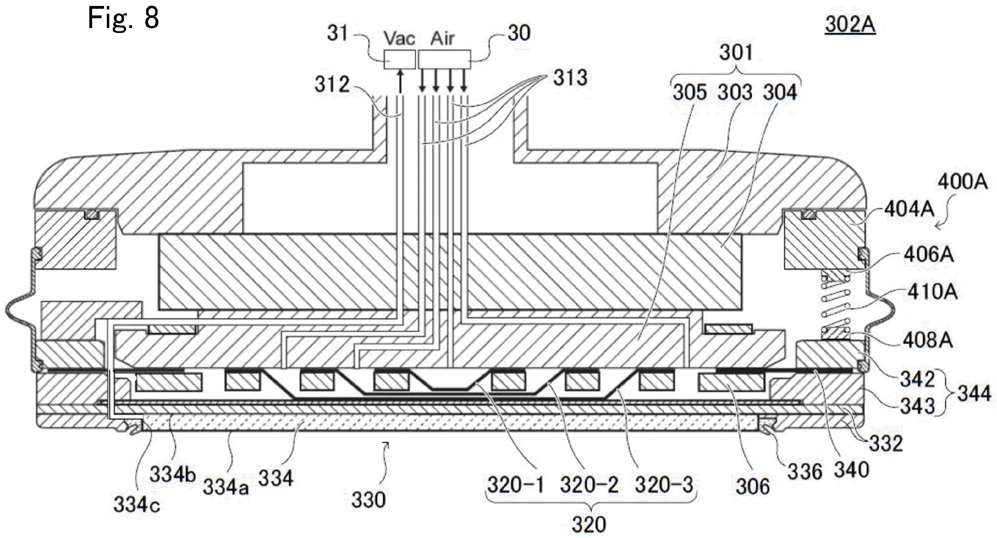

Fig. 8 is a cross-sectional view schematically illustrating a top ring according to a modification. A top ring 302A according to the modification is generally similar to the above-described top ring 302 except for the provision of a biasing mechanism 400A different from the biasing mechanism 400, and will be described omitting redundant descriptions. The biasing mechanism 400A according to the modification is constituted by an elastic member 410A. Known various elastic members, such as a coil spring, can be employed as the elastic member 410A. The top ring 302A according to the modification includes a lower flange 404A attached to the lower surface of the flange 303 of the base member 301.

Further, collars 406A and 408A are fixed to the lower flange 404A of the base member 301 and the frame member 344, respectively. Then, one end of the elastic member 410A (the first end portion) is attached to the collar 406A, and the other end of the elastic member 410A (the second end portion) is attached to the collar 408A. In the thus-configured top ring 302A according to the modification, the base member 301 and the frame member 344 are biased due to insertion of the compressed and deformed elastic member 410A between the lower flange 404A (the collar 406A) and the upper frame member 342 (the collar 408A). The biasing force exerted by the biasing mechanism 400A using the elastic member 410A is determined based on the relative distance between the lower flange 404A (the collar 406A) of the base member 301 and the upper frame member 342 (the collar 408A). Then, the biasing force for biasing the frame member 344 toward the polishing table 350 can be adjusted by selecting the elastic member 410A or adjusting the compression/deformation amount of the elastic member 410A based on an experiment, a simulation, or the like in advance. Due to that, the top ring 302A according to the modification allows the outer edge portion of the substrate WF to be pressed against the polishing table 350 with an adjusted pressing force to be then polished by an adjusted polishing amount, thereby achieving a polishing profile consistent between the central side and the outer edge side of the polygonal substrate, similarly to the top ring 302 according to the embodiment. The biasing mechanism 400A may be configured in such a manner that the elastic member 410A can be replaced with an elastic member having a desired elastic modulus by way of example. Further, the biasing mechanism 400A may be configured in such a manner that the positions of the collars 406A and 408A in the height direction can be adjusted using a spacer or the like. The elastic member 410A is attached to the lower flange 404A of the base member 301 and the upper frame member 342 of the frame member 344 in the example illustrated in Fig. 8, but is not limited to such an example. As one example, the elastic member 410A may be attached to the flange 303 of the base member 301 or may be attached to the stopper 346 of the frame member 344.

### <Modification 2>

The above-described modification 1 has been described assuming that the biasing mechanism 400A biases the frame member 344 and the base member 301 in the direction for separating the frame member 344 from the base member 301, i.e., the direction for pressing the substrate WF. However, the biasing mechanism 400A may be configured to apply the biasing force in a direction for moving the frame member 344 toward the base member 301 in a case where the polishing amount is larger on the outer edge portion of the substrate WF than on the central portion of the substrate WF.

### <Modification 3>

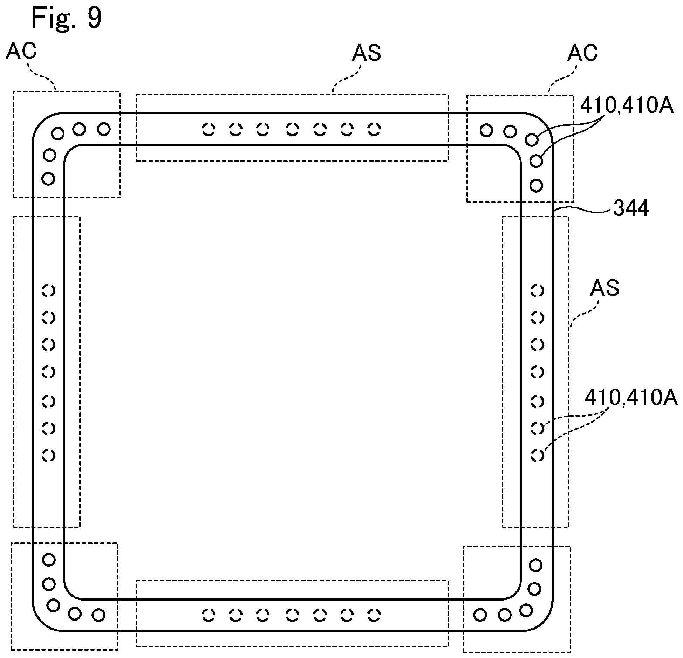

Fig. 9 illustrates one example of a portion in the frame member 344 that the piston 410 or the elastic member 410A is in contact with. The above-described embodiments and modifications have been described assuming that the pistons 410 or the elastic bodies 410A of the plurality of biasing mechanisms 400 and 400A are each provided in contact with the vicinity of the corner portion of the polygonal substrate WF, i.e., a corner region AC, which is a region including a corner portion of the frame member 344. However, without being limited to such an example, the biasing mechanisms 400 and 400A may be each provided in an edge region (for example, a region including the center of an edge portion but not including a corner portion) AS of the frame member 344 instead of or in addition to the corner region AC of the frame member 344. Even such an example can adjust the polishing amount on the outer edge portion of the substrate WF, achieving a polishing profile consistent between the central side and the outer edge side of the polygonal substrate, similarly to the top ring 302 according to the embodiment.

The present invention can also be described as the following embodiments.

[Embodiment 1] According to an embodiment 1, a top ring for holding a polygonal substrate is provided. The top ring includes a base member coupled to a rotational shaft, a substrate suction member, and a biasing mechanism. The substrate suction member includes a substrate suction body having a substrate suction surface for sucking the substrate and provided in communication with a pressure reduction module, a shielding member configured to shield an opposite surface of the substrate suction body from the substrate suction surface, and a frame member connected to the shielding member so as to surround at least a part of the base member. The biasing mechanism has a first end portion in contact with the base member and a second end portion in contact with the frame member, and is configured to apply a biasing force in a direction for moving the base member and the frame member toward or away from each other.

According to the embodiment 1, the polishing profile can be further consistent between the central side of the polygonal substrate and the outer edge side of the substrate.

[Embodiment 2] According to an embodiment 2, in the embodiment 1, the biasing mechanism includes a pneumatic actuator having the first end portion and the second end portion.

According to the embodiment 2, the polishing profile can be further consistent between the central side of the polygonal substrate and the outer edge side of the substrate using the pneumatic actuator.

[Embodiment 3] According to an embodiment 3, in the embodiment 2, the pneumatic actuator includes a cylinder attached to the base member and capable of receiving working fluid therein, a diaphragm disposed in the cylinder, and a piston provided in contact with the frame member and displaceable according to a movement of the diaphragm.

[Embodiment 4] According to an embodiment 4, in the embodiment 2 or 3, the top ring further includes an elastic membrane configured to form a pressing chamber between the base member and the shielding member, and a fluid supply source configured to supply working fluid into the pressing chamber. The pneumatic actuator is actuated by the working fluid from the fluid supply source.

According to the embodiment 4, the biasing mechanism can be formed using the fluid supply source for supplying the working fluid to the pressing chamber, and therefore the number of parts can be reduced.

[Embodiment 5] According to an embodiment 5, in the embodiment 1, the biasing mechanism is an elastic member having the first end portion and the second end portion.

According to the embodiment 2, the polishing profile can be further consistent between the central side of the polygonal substrate and the outer edge side of the substrate using the elastic member.

[Embodiment 6] According to an embodiment 6, in the embodiments 1 to 5, the frame member includes a stopper connecting different portions of this frame member in an arch-like manner across inside the frame. The base member includes a contact portion that limits a movement of the substrate suction member relative to the base member in a height direction by contacting the stopper. The second end portion of the biasing mechanism is in contact with the stopper.

According to the embodiment 6, the biasing mechanism can be formed using the stopper for limiting a movement of the subtraction suction member in the height direction.

[Embodiment 7] According to an embodiment 7, in the embodiments 1 to 6, the second end portion of the biasing mechanism is in contact with a corner region of the frame member as viewed from a direction perpendicular to the substrate suction surface.

[Embodiment 8] According to an embodiment 8, in the embodiments 1 to 7, the second end portion of the biasing mechanism is in contact with an edge region of the frame member as viewed from a direction perpendicular to the substrate suction surface.

[Embodiment 9] According to an embodiment 9, in the embodiments 1 to 8, the top ring further includes an elastic membrane configured to form a pressing chamber between the base member and the shielding member.

According to the embodiment 9, the substrate held by the top ring can be pressed by increasing the pressure in the pressing chamber.

[Embodiment 10] According to an embodiment 10, in the embodiment 9, the elastic membrane is configured to form a plurality of pressing chambers concentrically between the base member and the shielding member.

According to the embodiment 10, the substrate held by the top ring can be pressed by increasing the pressures in the plurality of concentric pressing chambers.

[Embodiment 11] According to an embodiment 11, in the embodiments 1 to 10, the first end portion and the second end portion are spaced apart from the substrate suction body as viewed from a direction perpendicular to the substrate suction surface.

[Embodiment 12] According to an embodiment 12, in the embodiments 1 to 11, the substrate suction body is made from a porous material.

[Embodiment 13] According to an embodiment 13, in the embodiments 1 to 12, the top ring further includes a band connecting an outer side surface of a portion of the base member that is not surrounded by the frame member, and an outer side surface of the frame member.

[Embodiment 14] According to an embodiment 14, a substrate polishing apparatus is provided. The substrate polishing apparatus includes the top ring according to any one of the embodiments 1 to 13; and a table configured to hold a polishing pad.

According to the embodiment 14, advantageous effects similar to the above-described embodiments can be brought about.

[Embodiment 15] According to an embodiment 15, a substrate polishing apparatus is provided. The substrate polishing apparatus includes the top ring according to the embodiment 9 or 10, a table configured to hold a polishing pad, and a controller configured to control supply of working fluid to the pressing chamber(s) and the biasing force exerted by the biasing mechanism in such a manner that a film thickness distribution of the substrate matches a target film thickness distribution.

According to the embodiment 15, the polishing profile can be further consistent between the central side of the polygonal substrate and the outer edge side of the substrate by the controller controlling the supply of the working fluid to the pressing chamber(s) and the biasing force exerted by the biasing mechanism.

Having described the embodiments of the present invention, the above-described embodiments of the invention are intended to only facilitate the understanding of the present invention, and are not intended to limit the present invention thereto. It is apparent that the present invention can be modified or improved without departing from the spirit thereof, and the present invention includes equivalents thereof. Further, the embodiments and the modifications can be combined in any manner and each component described in the claims and the specification can be combined in any manner or omitted in any manner within a range that allows it to remain capable of solving at least a part of the above-described problems or bringing about at least a part of the above-described advantageous effects.

The present application is based on and claims the benefit of priority of Japanese Patent Application No. 2023-202452 filed on November 30, 2023. The entire disclosure of Japanese Patent Application No. 2023-202452 including the specification, the claims, the drawings, and the abstract is incorporated herein by reference in its entirety. The entire disclosure of Japanese Patent Application Public Disclosure No. 2023-57047 (PTL 1) including the specification, the claims, the drawings, and the abstract is incorporated herein by reference in its entirety.

### REFERENCE SIGNS LIST

- 18: top ring shaft (rotational shaft)
- 30: pressure adjustment unit
- 31: pressure reduction module
- 300: polishing unit
- 301: base member
- 302: top ring
- 309: pad
- 320: elastic membrane
- 330: substrate suction member
- 332: shielding member
- 334: substrate suction body
- 334a: substrate suction surface
- 336: elastic seal member
- 340: elastic member
- 342: upper frame member
- 343: lower frame member
- 344: frame member
- 345: band
- 346: stopper
- 350: polishing table
- 352: polishing pad
- 400, 400A: biasing mechanism
- 401: cylinder
- 402: upper cylinder housing
- 404: lower cylinder housing
- 406A, 408A: collar
- 408: diaphragm
- 410: piston
- 410A: elastic member
- 900: controller
- 900a: storage device
- 1000: substrate polishing apparatus
- WF: substrate

## Claims

1. A top ring configured to hold a polygonal substrate, the top ring comprising:
a base member coupled to a rotational shaft;
a substrate suction member including a substrate suction body having a substrate suction surface for sucking the substrate and provided in communication with a pressure reduction module, a shielding member configured to shield an opposite surface of the substrate suction body from the substrate suction surface, and a frame member connected to the shielding member so as to surround at least a part of the base member; and
a biasing mechanism having a first end portion in contact with the base member and a second end portion in contact with the frame member, the biasing mechanism being configured to apply a biasing force in a direction for moving the base member and the frame member toward or away from each other.

2. The top ring according to claim 1, wherein the biasing mechanism includes a pneumatic actuator having the first end portion and the second end portion.

3. The top ring according to claim 2, wherein the pneumatic actuator includes
a cylinder attached to the base member and capable of receiving working fluid therein,
a diaphragm disposed in the cylinder, and
a piston provided in contact with the frame member and displaceable according to a movement of the diaphragm.

4. The top ring according to claim 2, further comprising:
an elastic membrane configured to form a pressing chamber between the base member and the shielding member; and
a fluid supply source configured to supply working fluid into the pressing chamber,
wherein the pneumatic actuator is actuated by the working fluid from the fluid supply source.

5. The top ring according to claim 1, wherein the biasing mechanism is an elastic member having the first end portion and the second end portion.

6. The top ring according to claim 1, wherein the frame member includes a stopper connecting different portions of this frame member in an arch-like manner across inside the frame,
wherein the base member includes a contact portion that limits a movement of the substrate suction member relative to the base member in a height direction by contacting the stopper, and
wherein the second end portion of the biasing mechanism is in contact with the stopper.

7. The top ring according to claim 1, wherein the second end portion of the biasing mechanism is in contact with a corner region of the frame member as viewed from a direction perpendicular to the substrate suction surface.

8. The top ring according to claim 1, wherein the second end portion of the biasing mechanism is in contact with an edge region of the frame member as viewed from a direction perpendicular to the substrate suction surface.

9. The top ring according to claim 1, further comprising an elastic membrane configured to form a pressing chamber between the base member and the shielding member.

10. The top ring according to claim 9, wherein the elastic membrane is configured to form a plurality of pressing chambers concentrically between the base member and the shielding member.

11. The top ring according to claim 1, wherein the first end portion and the second end portion are spaced apart from the substrate suction body as viewed from a direction perpendicular to the substrate suction surface.

12. The top ring according to claim 1, wherein the substrate suction body is made from a porous material.

13. The top ring according to claim 1, further comprising a band connecting an outer side surface of a portion of the base member that is not surrounded by the frame member, and an outer side surface of the frame member.

14. A substrate polishing apparatus comprising:
the top ring according to any one of claims 1 to 13; and
a table configured to hold a polishing pad.

15. A substrate polishing apparatus comprising:
the top ring according to claim 9 or 10;
a table configured to hold a polishing pad; and
a controller configured to control supply of working fluid to the pressing chamber(s) and the biasing force exerted by the biasing mechanism in such a manner that a film thickness distribution of the substrate matches a target film thickness distribution.
